# EUROPÄISCHE PATENTSCHRIFT

(11) **EP 3 035 551 B1**
(45) Veröffentlichungstag und Bekanntmachung des Hinweises auf die Patenterteilung: **14.08.2019**
(21) Anmeldenummer: 15201719.0
(22) Anmeldetag: 21.12.2015
(51) Int. Cl.: H04B 3/54

(54) **VERFAHREN UND VORRICHTUNG ZUM SELBSTTEST DER MESSGENAUIGKEIT EINES ELEKTRIZITÄTSZÄHLERS**
METHOD AND DEVICE FOR THE SELF-TEST OF THE MEASUREMENT PRECISION OF AN ELECTRICITY METER
PROCÉDÉ ET DISPOSITIF POUR L'AUTOTEST DE L'EXACTITUDE DE MESURE D'UN COMPTEUR D'ELECTRICITE

(30) Priorität: 19.12.2014 DE 102014018809
(43) Veröffentlichungstag der Anmeldung: 22.06.2016
(73) Patentinhaber: EMH metering GmbH & Co. KG, 19258 Gallin (DE)
(72) Erfinder: LÜBECK, Felix, 21614 Buxtehude (DE)
(74) Vertreter: Hauck Patentanwaltspartnerschaft mbB

(56) Entgegenhaltungen:
- EP-A2- 2 675 034
- DE-A1-102008 044 909
- DE-T2- 69 824 659
- US-A- 4 271 390
- US-A1- 2004 037 221

## Beschreibung

Zur Übertragung von Daten über vorhandene Stromnetze sind verschiedenste Verfahren und Vorrichtungen bekannt, für die im Folgenden der geläufige Oberbegriff Powerline Communication (PLC) verwendet werden soll. Bei üblichen Verfahren entnehmen Sendeeinrichtungen dem Stromnetz bei der Nennfrequenz Leistung, und speisen bei einer von der Nennfrequenz des Stromnetzes abweichenden Frequenz, meist bei höheren Frequenzen bzw. in höheren Frequenzbändern, Leistung in das Stromnetz ein. Aus WO 00/29857 ist auch eine Sendeeinrichtung bekannt, die unterhalb der Nennfrequenz Leistung einspeist. Entsprechende Vorrichtungen umfassen ein Netzteil, dass dem Stromnetz bei der Nennfrequenz Leistung entnimmt und in eine Kleinspannung wandelt, eine Steuerung, eine Vorrichtung zur Signalerzeugung, einen Verstärker und eine Koppeleinheit zur Einspeisung des verstärkten Sendesignals in das Stromnetz. Dieser übliche Aufbau bedingt Leistungsverluste mindestens im Netzteil und im Verstärker. Diese Verluste hängen zudem üblicherweise von der lokalen Netzimpedanz ab. An einer beabstandeten, dedizierten Empfangseinrichtung wird mit geeigneten Mitteln das auf die Netzspannung aufmodulierte Spannungssignal erfasst, und daraus werden die gesendeten Daten rekonstruiert. Dabei hängt die empfangene Signalamplitude vom Abstand ab, wobei allerdings nicht allein die Leitungslänge von Bedeutung ist, sondern in erster Linie die Anzahl, Art und Position der an dieser Leitung angeschlossenen Verbraucher.

WO 2006/034866 A1 beschreibt eine vom vorgesagten abweichende Vorrichtung zur Datenübertragung. Dort sendet ein "Modulator 30" Daten an eine beabstandete, dedizierte Empfangseinrichtung "Empfangseinheit 50", indem ein Stromkreis einer Hausinstallation intermittierend vom Netz getrennt und kurzgeschlossen wird. Der Umschalter 31 fungiert als Mischer, der die Netzspannung, die als Trägerfrequenz fungiert, mit einem von der Steuereinheit 33 erzeugten Signal mischt. Leistungsverluste in einem Netzteil bzw. Verstärker entfallen. Unter dem Aspekt der Leistungseffizienz wird ein Fortschritt gegenüber den eingangs erwähnten Verfahren erzielt. Nutzbar ist dies Verfahren jedoch offensichtlich nur in den Grenzen, in denen ein geeigneter, niederohmiger Umschalter 31 realisierbar ist, der den erheblichen Anforderungen gewachsen ist. Zudem muss sichergestellt sein, dass das aufmodulierte Nutzsignal und die zwangsläufig erzeugten, unerwünschten Mischprodukte nicht zu EMV-Problemen bei angeschlossenen Verbrauchern führen.

Gemeinsamer Nachteil der bekannten PLC Verfahren ist, dass eine dedizierte Empfangseinrichtung benötigt wird. Auch in Anwendungen im Zusammenhang mit fernauslesbaren Elektrizitätszählern wird eine dedizierte Empfangseinrichtung benötigt. Dies gilt selbst dann, wenn Elektrizitätszähler und Empfangseinrichtung einstückig hergestellt sind, um Spareffekte bei Gehäuse, Netzteil und Montage zu erzielen. Beispielhaft sei WO 2005059572 A1 angeführt, wo in einem Zähler 9 ein "energy measurement module 907" und ein "power line modem 906" getrennte Baugruppen darstellen.

Ein weiterer gemeinsamer Nachteil der bekannten PLC Verfahren ist, dass vorhandene Stromnetze dazu ausgelegt sind, elektrische Energie mit Netzfrequenz zu übertragen. Sie sind jedoch nicht dazu ausgelegt, elektrische Energie mit Vielfachen oder Bruchteilen der Netzfrequenz zu übertragen. Zudem können übliche Verbraucher Störsignale erzeugen, die so groß sind, dass während der Aktivität dieser Verbraucher die Kommunikation mit bekannten PLC Verfahren zum Erliegen kommt. Es gibt zwar Regulierungen wie z.B. die Norm DIN EN 50065-1 und Frequenzzuweisungen, die beispielsweise das sogenannte "CENELEC-A Band" ausschließlich für metering-Anwendungen reservieren, aber diese Norm reguliert lediglich die Erzeugung von Nutz- und Störsignalen durch für Kommunikationszwecke vorgesehene Geräte (also für PLC-Geräte), sie trifft keine Aussagen über die Erzeugung von Störsignalen durch Verbraucher, die nicht der Kommunikation über Stromnetze dienen, wie beispielsweise Motoren, Elektroschweißgeräte, oder Ladegeräte für Mobiltelefone. Aus diesem Grunde bedingt die Kommunikation per PLC mehr Unwägbarkeiten als andere Verfahren zur Datenübertragung.

Aus der Druckschrift US 2004/0037221 A1 sind ein Verfahren und eine Vorrichtung zur Datenübertragung über ein Stromnetz bekannt geworden. Das Verfahren beruht auf einer mit der Netzfrequenz synchronisierten Modulation eines Verbrauchers.

Aus der Druckschrift EP 2 675 034 A2 sind Verfahren und Vorrichtungen zur Messung des Leistungsflusses in elektrischen Verteilnetzen bekannt geworden.

Aus der Druckschrift DE 698 24 659 T2 ist ein Verfahren bekannt geworden, bei dem zur Kalibrierung eines Messwandlers eines elektronischen Elektrizitätszählers eine bekannte Leistung gemessen wird. Weicht die gemessene Leistung von der bekannten Leistung ab, wird ein analoges Eingabesignal durch Ansteuern eines mit einem Transistor angesteuerten Spannungsteilers gemäß einem bestimmten Betriebszyklus so angepasst, dass die korrekte Leistung gemessen wird.

Aufgabe der vorliegenden Erfindung ist es, ein Verfahren und eine Vorrichtung für einen Selbsttest der Messgenauigkeit eines Elektrizitätszählers zur Verfügung zu stellen.

Die Aufgabe wird gelöst durch das Verfahren mit den Merkmalen des Anspruchs 1 und eine Vorrichtung mit den Merkmalen des Anspruchs 2. Vorteilhafte Ausgestaltungen sind in den Unteransprüchen angegeben.

Kurzbeschreibung der Figuren:
Figur 1 zeigt eine Vorrichtung zur Übertragung von Daten über ein vorhandenes Stromnetz mit einem Fernsehgerät, das Daten sendet, indem es einen Wirkverbrauch moduliert, und einen Elektrizitätszähler, der den Wirkverbrauch im Stromnetz erfasst und die aufmodulierten Daten rekonstruiert.
Figur 2 zeigt einen Elektrizitätszähler mit einem Messwerk einfacher Bauart. Figur 2 verdeutlicht, dass für die Übertragung von Daten keine dedizierten Empfangsschaltkreise im Elektrizitätszähler benötigt werden und keine besonderen Anforderungen an das Messwerk des Elektrizitätszählers gestellt werden.
Figur 3 zeigt eine Vorrichtung mit einem Elektrizitätszähler einfacher Bauart und einem Gateway zur Zählerfernauslesung. Figur 3 verdeutlicht, dass keine besonderen Elektrizitätszähler benötigt werden, sondern handelsübliche Elektrizitätszähler als Empfänger fungieren können.
Figur 4 zeigt ein Gerät, das Daten sendet, indem es einen Blindverbrauch moduliert.
Figur 5 zeigt ein Gerät, das Daten sendet, indem es Energie über eine Netzperiode hinaus speichert.
Figur 6a-d zeigt beispielhaft einige Beispiele unterscheidbarer Signale, die jeweils unterschiedliche Daten repräsentieren können.
Figur 7 zeigt ein Gerät, das dazu ausgebildet ist, erste Daten zu senden, die ein Aktivieren eines ersten Schalters repräsentieren, und das dazu ausgebildet ist, zweite Daten zu senden, die ein Aktivieren eines zweiten Schalters repräsentieren.
Figur 8 zeigt eine Vorrichtung zur Übertragung einer Prüfleistung über ein vorhandenes Stromnetz, die einen Wirkverbrauch moduliert und die einen Elektrizitätszähler, der die Modulation des Verbrauchs im Stromnetz erfasst, auf korrekte Funktion seines Messwerks überprüft.
Figur 9 zeigt einen Elektrizitätszähler, der dazu ausgebildet ist, seine Messwerke automatisch zu testen.
Figur 10 zeigt einen kostenoptimierten Elektrizitätszähler, der dazu ausgebildet ist, seine Messwerke automatisch zu testen.
Figur 11 zeigt einen Elektrizitätszähler, der zum automatischen Test seiner Messwerke einen Referenzverbraucher enthält.

Ausführliche Beschreibung der in den Figuren gezeigten Ausführungsbeispiele:

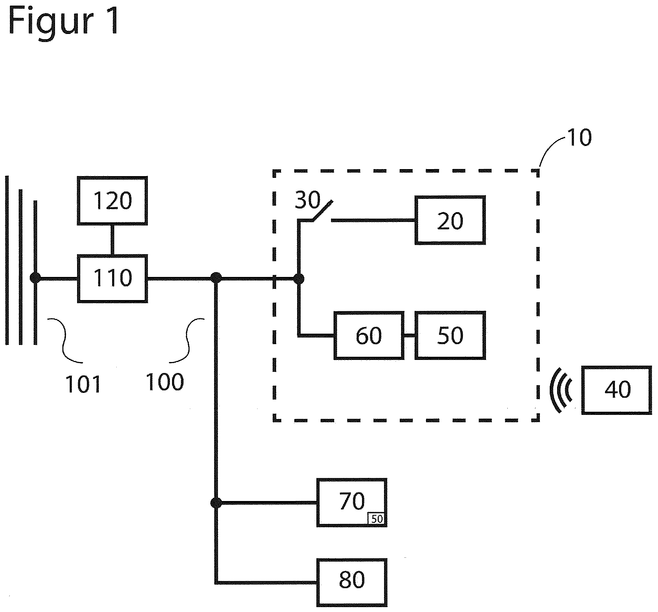

Figur 1 zeigt ein Fernsehgerät 10 mit einem Wirkverbraucher 20 und einem Schalter 30, mit dem der Wirkverbraucher ein- und ausschaltbar ist. Eine Fernbedienung 40 und Bedienknöpfe 50 sind dazu vorgesehen, Benutzereingaben von einem Benutzer anzunehmen. Eine Steuerung 60 verarbeitet Benutzereingaben. Des Weiteren ist ein Wasserkocher 70 dargestellt. Weitere Verbraucher 80 sind summarisch dargestellt. Auch an diesem Wasserkocher 70 ist ein Bedienknopf 50 dazu vorgesehen, Benutzereingaben von einem Benutzer anzunehmen. Die Geräte sind über die elektrische Installation 100 eines Haushalts mit dem Elektrizitätszähler 110 verbunden, der mit einem Kommunikationsgerät 120 ausgestattet ist. Der Elektrizitätszähler 110 ist zudem verbunden mit einem öffentlichen Stromnetz 101.

Das Kommunikationsgerät 120 ist dazu vorgesehen, Zählerstände zwecks Rechnungslegung an einen Energieversorger zu übermitteln. Das Kommunikationsgerät 120 ist weiterhin dazu vorgesehen, aus Mustern im Stromverbrauch auf Notfälle zu schließen, und in Notfällen Alarmmeldungen zu senden. Dabei wird aus Benutzereingaben an der Fernbedienung 40 respektive Bedienknöpfen 50 auf eine Benutzeraktivität geschlossen. Der Wasserkocher 70 ist einfachster Bauart, weist keine eigene Steuerung auf, sondern lediglich einen Heizwiderstand mit positivem Temperaturkoeffizienten. Ein Einschalten des Wasserkochers bewirkt einen markanten Sprung der im Elektrizitätszähler 110 gemessenen Wirkleistung, gefolgt von einem exponentiellen Abklingen. Mit bekannten Verfahren der Mustererkennung kann aus den Messwerten der Wirkleistung auf die Benutzeraktivität "Wasser kochen" geschlossen werden und im Falle von Auffälligkeiten kann ein Alarm über das Kommunikationsgerät 120 abgesetzt werden.

Im Falle des Fernsehgeräts 10 stellt sich die Situation gegensätzlich dar. Es hat sich gezeigt, dass bei üblichen Fernsehgeräten die aufgenommene Wirkleistung sehr stark von den dargestellten Bildinhalten (Helligkeits schwankungen) abhängt, und sehr wenig von Benutzereingaben. Um dennoch einen Rückschluss von Messwerten der Wirkleistung auf die Benutzeraktivität zu ermöglichen, weist das Fernsehgerät 10 eine Steuerung 60 auf, die dazu ausgebildet ist, in einem definierten Zeitraum von beispielsweise 2 Minuten nach einer Benutzereingabe den Schalter 30 mit einem definierten Muster anzusteuern, und so den Leistungsfluss vom Elektrizitätszähler 110 zum Fernsehgerät 10 zu modulieren. Diese Modulation wird im Elektrizitätszähler 110 erfasst, und so auf die Benutzeraktivität geschlossen. Der Wirkverbraucher 20 ist in diesem Ausführungsbeispiel ein für die Erzeugung des Fernsehbildes notwendiger Verbraucher, und zwar beispielsweise ein Recheneinheit, die in komprimierter Form übertragene Bilddaten dekomprimiert. Diese Recheneinheit weist einen Energiesparmodus auf, in dem sie keine Berechnungen ausführt, und einen Rechenmodus, in dem Sie Bilddaten mit doppelter Geschwindigkeit dekomprimiert. Der Schalter 30 verkörpert also die Umschaltung zwischen Energiesparmodus und Rechenmodus. Die Steuerung 60 weist nach einer Benutzeraktivität die Recheneinheit an, mit doppelter Geschwindigkeit Bilddaten zu verarbeiten. Die dabei auf Vorrat produzierten Bilddaten werden in einem geeigneten Puffer gespeichert. Nach beispielsweise 10 Sekunden weist die Steuerung 60 die Recheneinheit an, einen Energiesparmodus anzunehmen. Die auf Vorrat produzierten Bilddaten werden dann dem genannten Puffer entnommen. Nach weiteren 10 Sekunden weist die Steuerung 60 die Recheneinheit an, wieder mit doppelter Geschwindigkeit Bilddaten zu verarbeiten, und so fort, bis nach zwei Minuten ohne weitere Benutzereingabe die Steuerung 60 die Recheneinheit anweist, mit einfacher Geschwindigkeit Bilddaten zu verarbeiten, und somit die Modulation zu beenden. Für das Senden wird also keine zusätzliche Sendeleistung aufgewendet, es werden lediglich die Zeitpunkte sowieso erforderlicher Rechenoperationen verlagert. Die resultierende Latenz von 10 Sekunden kann sich störend auswirken. Deshalb kann die erfindungsgemäße Übertragung von Daten über das Stromnetz über einen Bedienknopf 50 komplett deaktiviert werden, so dass ein nicht überwachungsbedürftiger Benutzer ein Tor in einer Live-Fußballübertragung nicht später sieht als seine Nachbarn. Das Fernsehgerät 10 muss also nicht speziell für eine überwachungsbedürftige Zielgruppe entwickelt und gefertigt werden, sondern ist generell nutzbar. Insgesamt werden also ähnliche Effekte erreicht wie aus US 6,559,766 B2 bekannt. Dazu werden aber nicht IP-Daten zum Fernseher überwacht, sondern der Stromfluss zum Fernseher. Deshalb kann grundsätzlich jede Art von Fernseher gemäß diesem Ausführungsbeispiel ausgelegt werden, nicht nur solche, die per IP die Bildinformation empfangen. Es ist lediglich vorauszusetzen, dass ein interner Verbraucher des Fernsehers für einen intermittierenden Betrieb ausgelegt werden kann.

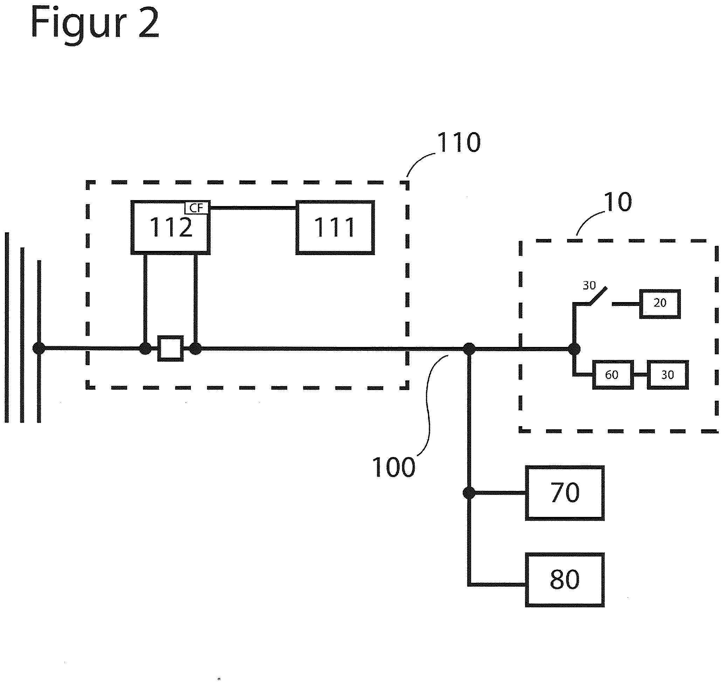

Figur 2 zeigt den Elektrizitätszähler 110 aus Figur 1 im Detail, in einer Ausführung mit einem Messchip 112. Als Messchip ist der Messchip ADE 7755 vorgesehen. Die Schaltung entspricht dem im Dokument Application Note AN-559 von Analog Devices als "Figure 1" bezeichneten Referenzdesign. Der Nullleiter ist nicht dargestellt. Wie in diesem Dokument im Abschnitt "Interfacing the ADE7755 to a Microcontroller for Energy Measurement" erklärt, ist der Ausgang CF mit dem Mikrocontroller 111 verbunden. Der Zähler ist für eine Maximalleistung von 27,5 KW ausgelegt. Bei 27,5 KW liefert CF eine Ausgangsfrequenz von 5,5 KHz. 5500 Pulse repräsentieren also eine Elektrizitätsmenge von 27,5 KWs, ein Puls repräsentiert ca. 5 Ws. Zum Zwecke der Elektrizitätszählung werden die Pulse im Mikrocontroller 111 gezählt. Zum Zwecke der Leistungsbestimmung werden die Pulse jeweils über feste Blöcke von 1 Sekunde Dauer integriert.

Durch weitere Verbraucher 80 und das Fernsehgerät 10 wird in einem Zeitraum ohne Benutzeraktivität eine Leistung von 300 Watt verbraucht. Als Reaktion auf einen Wechsel des Fernsehprogramms durch den Benutzer schaltet die Steuerung 60 die Leistungsaufnahme des internen Verbrauchers 20 im 10 Sekundentakt zwischen den Werten 0 und 20 Watt. Die Leistung, die in der elektrischen Installation 100 des Haushalts übertragen wird, wechselt nun zwischen 310 Watt und 290 Watt. Die Zahl der innerhalb einer Sekunde vom Ausgang CF des Messchips 112 gesendeten und von dem Mikrocontroller 111 gezählten Pulse pendelt also zwischen 62 und 58. In der Software des Mikrocontroller 111 ist ein geeigneter digitaler Tiefpass zur Entfernung von Ripple und eine übliche Methode der Mustererkennung realisiert, die die Modulation erkennt. Dabei kann es sich beispielsweise um eine Korrelationsanalyse oder einen Hinkley-Detektor handeln. Dabei kann insbesondere die Lehre aus EP 2010873 A1 und des dort zitierten Standes der Technik berücksichtigt werden, um gleichzeitig nach Sprüngen unterschiedlicher Höhe zu suchen, nämlich einerseits nach großen Sprüngen, die aus der Betätigung des Wasserkochers 70 resultieren, und andererseits nach kleinen Sprüngen, die aus der Sendeaktivität des Fernsehgeräts 10 resultieren. Der Fachmann wird erkennen, dass die beschriebene Verwendung des Messchips ADE7755 die Fähigkeit, erfindungsgemäße Datenübertragungen zu empfangen. beschränkt, da die innerhalb des Messchips verfügbaren Informationen bereits im Messchip reduziert werden auf ein für die Elektrizitätszählung benötigtes Minimum, das am Ausgang CF ansteht. Dieser Baustein ist für den dargestellten Zweck also nicht besonders günstig, sondern im Gegenteil besonders ungünstig. Dieses Ausführungsbeispiel soll verdeutlichen, dass das beschriebene Verfahren selbst unter empfängerseitig besonders ungünstigen Voraussetzungen funktioniert. Damit unterscheidet es sich von als Rundsteuertechnik bekannten PLC-Verfahren. Für Rundsteuertechnik sind hochwertige Messwerke für Elektrizitätszähler bekannt, die in der Lage sind, gleichsam nebenbei Rundsteuersignale zu empfangen. Mit kostenoptimierten Messwerken wie dem oben gezeigten ist dies jedoch unmöglich.

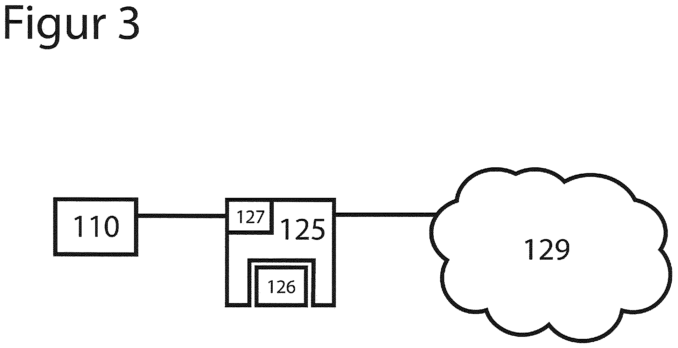

Figur 3 zeigt einen Elektrizitätszähler 110 mit einem Smart-Meter-Gateway 125. Das Smart-Meter- Gateway 125 weist ein Einsteckmodul 126 auf. Das Smart-Meter-Gateway 125 stellt ein Kommunikationsgerät mit besonderen Fähigkeiten zur gesicherten Übertragung von Daten dar. Das Smart-Meter-Gateway 125 empfängt über eine Schnittstelle 127 Datentelegramme, die Zählerstände und Werte der Momentanleistung verkörpern. Die Datentelegramme werden typischerweise in einem Abstand von 1-4 Sekunden verschickt. Das Smart-Meter-Gateway 125 ist dazu vorgesehen, regelmäßig Verrechnungsdaten über ein Mobilfunknetz 129 an eine Verrechnungsstelle zu senden.

Das Einsteckmodul 126 ist dazu vorgesehen, den zeitlichen Verlauf der Momentanleistung, also des Stromverbrauchs, zu analysieren, und aus Mustern im Stromverbrauch auf Notfälle zu schließen. Das Einsteckmodul 126 ist dazu vorgesehen, in Notfällen das Smart-Meter-Gateway 125 zu veranlassen, über das Mobilfunknetz 129 Alarmmeldungen zu senden. Die Modularisierung ist so gewählt, dass das Smart-Meter-Gateway 125 den Spezifikationen des Bundesamtes für Sicherheit in der Informationstechnik genügen kann, und zwar insbesondere BSI TR-03109: https://www.bsi.bund.de/SharedDocs/Downloads/DE/BSI/Publikationen/Technische Richtlinien/TR03109/TR03109.pdf und BSI-CC-PP-0073: https://www.bsi.bund.de/DE/Themen/SmartMeter/Schutzprofil Gateway/schutzprof il_smart_meter_gateway_node.html, ohne dass das Einsteckmodul 126 den Anforderungen dieser technischen Richtlinien für den sicheren Bereich zu unterwerfen ist.

Der Fachmann wird erkennen, dass in dieser Ausführung die Fähigkeit, erfindungsgemäße Datenübertragungen zu empfangen, beschränkt ist, da die innerhalb des Zählers verfügbaren Informationen und insbesondere die Datenrate bzw. die Bandbreite bereits im Zähler reduziert werden. Diese Ausführung ist für den dargestellten Zweck also nicht besonders günstig, sondern im Gegenteil besonders ungünstig. Dieses Beispiel soll verdeutlichen, dass das beschriebene Verfahren selbst unter empfängerseitig besonders ungünstigen Voraussetzungen funktioniert.

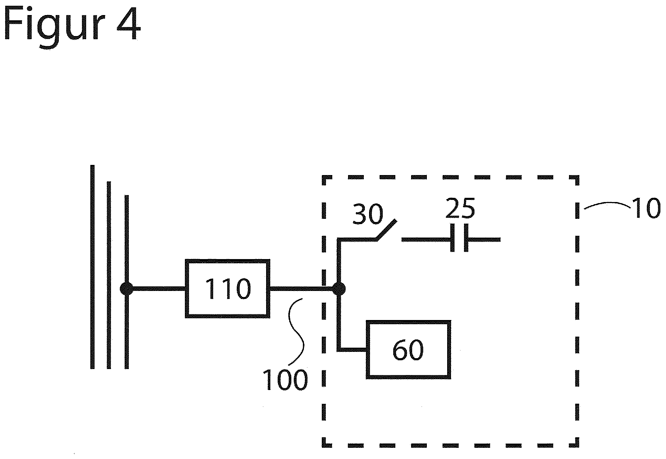

Figur 4 zeigt ein Fernsehgerät 10 mit einem Blindverbraucher 25 und einem Schalter 30, mit dem der Blindverbraucher ein- und abschaltbar ist. Der Nullleiter ist nicht dargestellt. Fernbedienung und Bedienknöpfe, weitere Verbraucher etc. entsprechend Figur 1 sind ebenfalls vorgesehen, aber nicht dargestellt.

Das Fernsehgerät 10 ist über die elektrische Installation 100 des Haushalts mit dem Elektrizitätszähler 110 verbunden, der zur Zählung von Blindenergie eingerichtet ist.

Das Fernsehgerät 10 weist eine Steuerung 60 auf, die dazu ausgebildet ist, in einem definierten Zeitraum von 2 Minuten nach einer Benutzereingabe den Schalter 30 mit einem definierten Muster anzusteuern, und so den Leistungsfluss vom Elektrizitätszähler 110 zum Fernsehgerät 10 zu modulieren. Diese Modulation wird im Elektrizitätszähler 110 erfasst, und so auf die Benutzeraktivität geschlossen. Der Blindverbraucher 25 ist in diesem Ausführungsbeispiel ein zum Zwecke der Datenaussendung zusätzlich verbauter Kondensator. Der Schalter 30 ist ein geeignetes Halbleiterbauelement. Für das Senden wird keine Wirkleistung übertragen.

Vorteil gegenüber der in Figur 1 gezeigten Ausführung ist der einfache und universelle Aufbau, der keine besonderen Annahmen trifft über in einem Gerät vorhandene, modulierbare Verbraucher von Wirkleistung. Nachteil sind die zusätzlichen Kosten für die beiden zusätzlichen Bauelemente und die Einschränkung auf einen Elektrizitätszähler, der zur Zählung von Blindenergie eingerichtet ist.

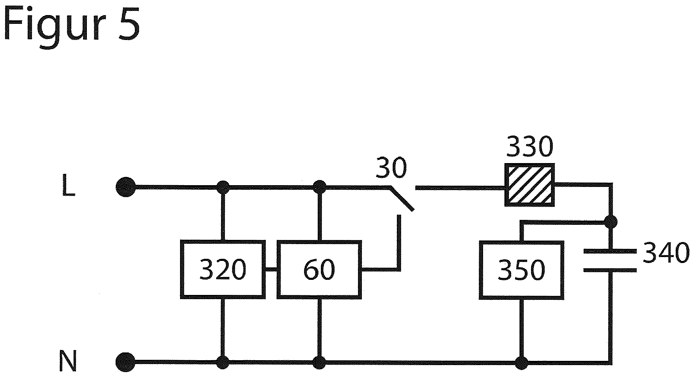

Figur 5 zeigt eine Vorrichtung zum Übertragen von Daten über eine elektrische Installation eines Haushalts, mit einem Schalter 30, einer Induktivität 330 und einem Kondensator 340. Eine Spannungsmesseinrichtung 320 misst die Momentanspannung in der elektrischen Installation. Eine Spannungsmesseinrichtung 350 misst die Spannung am Kondensator 340. Eine Steuerung 60 schaltet in Abhängigkeit von den Messwerten der Spannungsmesseinrichtungen 320 und 350 den Schalter 30. Dabei sind drei verschiedene Zustände der Steuerung vorgesehen. Erstens ist ein Leerlaufzustand vorgesehen, in dem der Schalter 30 dauerhaft geöffnet ist und der Kondensator 340 dauerhaft vom Netz getrennt ist.

Zweitens ist ein Ladezustand vorgesehen, in dem der Kondensator 340 langsam, beispielsweise über 500 Netzperioden hinweg, aufgeladen wird, indem der Schalter 30 jeweils dann kurzzeitig geschlossen wird, wenn die Momentanspannung in der elektrischen Installation ansteigt und die Spannung am Kondensator um ein weniges übertrifft. Schalten bei der fallenden Flanke der positiven Halbwelle oder bei beiden Flanken ist ebenfalls denkbar. Nur aus Gründen der Übersichtlichkeit wird hier nur eine der möglichen Varianten dargestellt. Diese Spannungsdifferenz fällt dann an der Induktivität 330 ab und bewirkt einen rampenförmigen Anstieg eines Ladestroms durch die Induktivität, der den Kondensator 340 auflädt. Sobald die Spannung am Kondensator die Spannung in der elektrischen Installation erreicht hat, kehrt sich das Vorzeichen der Spannung an der Induktivität 330 um, und der Ladestrom fällt wieder ab. Der Schalter 30 ist selbstlöschend ausgeführt, das heißt, er ist ausgebildet beim Unterschreiten eines Haltestroms den Stromfluss zu trennen. Dadurch wird der Aufwand für einen zusätzlichen, durch die Steuerung 60 abzufragenden Stromsensor eingespart. Und man vermeidet die Unsicherheit, die sich ergibt, wenn die Steuerung 60 aus dem Verlauf der Messwerte der Spannungsmesseinrichtungen 320 und 350 auf den Stromfluss schließt. Realisiert wird der Schalter 30 beispielsweise durch 2 Thyristoren, von denen jeweils einer passend zur Stromrichtung geschaltet wird. Steuerung 60 ist in diesem Fall dazu eingerichtet, mit zwei getrennten Pins jeweils den passenden Thyristor anzusteuern.

In einer beispielhaften Auslegung soll über einen Zeitraum von 10 Sekunden eine mittlere Leistung von 10 Watt entnommen werden. Dazu ist also im Kondensator eine Energie von 100 Wattsekunden zu speichern. Das ist erfüllbar, indem der Kondensator mit 2200 µF bemessen wird und er jeweils bis auf 300 V geladen wird. E=1/2 C ^{∗} U² =1/2 ^{∗} 2,2 ^{∗} 10⁻³ F ^{∗} 300² V²=99 Ws.

Zu diesen Anforderungen passende Kondensatoren sind bekannt und werden beispielsweise von der Firma Epcos unter der Typenbezeichnung B43564 bzw. B43584 vermarktet.

Beim Ladevorgang wird innerhalb von 10 Sekunden eine Ladungsmenge Q = U ^{∗} C = 300 V ^{∗} 2,2 ^{∗}10⁻³ F = 0,66 Coulomb übertragen, was einem mittleren Stromfluss von 66 mA entspricht. Die Vorrichtung könnte dazu ausgebildet werden, den Kondensator mit einem konstanten Stromfluss von 66mA aufzuladen. Die Steuerung würde also bei 500 konsekutiven positiven Halbwellen jeweils einmal kurzzeitig den Schalter 30 schließen, und zwar so, dass jeweils der 500. Teil der zu übertragenden Gesamtladung von 0,66 Coulomb den Schalter passiert. Dabei wäre der Leistungsfluss zu Beginn der Aufladung gering, da der Schalter dann jeweils bei niedriger Phasenspannung geschlossen wird, das Produkt aus Strom und Phasenspannung also gering ist. Zum Ende der Aufladung betrüge das Produkt aus Strom und Phasenspannung P=66mA^{∗}300V = 19,8 Watt, wäre mithin doppelt so hoch wie der Mittelwert. Diese Variante ist zum besseren Verständnis angegeben. Um eine ähnliche Modulation der Wirkleistung zu erzielen wie in der Ausführung gemäß Figur 1, wird der Kondensator tatsächlich mit einer im wesentlichen konstanten Leistung von 10 Watt aufgeladen. Deshalb ist der Stromfluss zu Beginn der Aufladung erhöht, und zum Ende der Aufladung hin reduziert.

Drittens ist ein Entladezustand vorgesehen, in dem der Kondensator 340 langsam, beispielsweise über 500 Netzperioden hinweg, entladen wird, indem der Schalter 30 jeweils dann kurzzeitig geschlossen wird, wenn die Momentanspannung in der elektrischen Installation abfällt (oder ansteigt, siehe oben) und die Spannung am Kondensator um ein weniges unterschreitet.

Die Steuerung 60 ist dazu eingerichtet, zweckmäßig zwischen Leerlauf, Ladezustand und Entladezustand zu wechseln, um Daten zu übertragen.

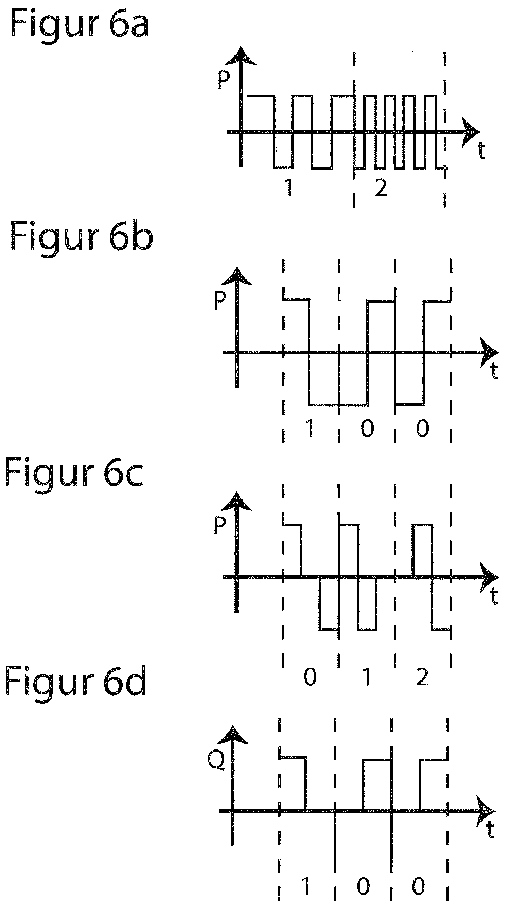

Figur 6a zeigt eine Modulation mittels Frequenzumtastung (Frequency Shift Keying). Ein Sender unterscheidet 2 Symbole, indem er einem Symbol eine höhere Frequenz, und dem anderen Symbol eine niedrigere Frequenz zuordnet. Wichtig ist die Gleichanteilsfreiheit des resultierenden Signals.

Figur 6b zeigt eine Modulation mittels Manchester-Code in der Codedefinition nach G.E. Thomas. Eine fallende Flanke bedeutet eine logische Eins, eine steigende Flanke eine logische Null. Wichtig auch hier die Gleichanteilsfreiheit des resultierenden Signals. Man erkennt, dass zur Übertragung des Symbols "1" zunächst für eine Zeitdauer von beispielsweise 10 Sekunden eine Leistung von beispielsweise 10 Watt aufgenommen wird, und für eine weitere Zeitdauer von 10 Sekunden eine Leistung von 10 Watt abgegeben wird. Die Übertragung des Symbols "1" dauert in diesem Beispiel also 20 Sekunden. In diesem Fall spricht man von einer Bitrate, die 0,1 Bit pro Sekunde beträgt, und einer Baudrate, die 0,05 Symbole pro Sekunde beträgt.

Für die anschließende Übertragung des Symbols "0" ist erneut eine Leistung von 10 Watt abzugeben. Soll eine Vorrichtung gemäß Ausführungsbeispiel aus Figur 5 mit einem Manchestercode senden, dann benötigt sie einen Kondensator mit doppelter Kapazität, der also ausgelegt ist, die Energiemenge zu speichern, die zwei Bits zugeordnet ist.

Figur 6c zeigt eine Modulation, die eine Wiederholung gleicher Bits vermeidet. Sie ist besonders gut geeignet für eine Vorrichtung gemäß Ausführungsbeispiel aus Figur 5. Denn hier folgt jeweils auf einen Aufladezyklus ein Entladezyklus. Variiert wird die Position eines Leerlaufzyklus. In diesem Beispiel dauert bei einer Bitdauer von 10 Sekunden die Übertragung eines Symbols 30 Sekunden.

Figur 6d zeigt eine Modulation der Blindleistung Q mit einem Offset-behafteten Manchester-Code. Sie ist besonders gut geeignet für eine Vorrichtung gemäß Ausführungsbeispiel aus Figur 4. Der Offset ergibt sich bei einer Ausführung des Senders gemäß Figur 4. Er könnte durch zusätzliche schaltungstechnische Maßnahmen vermieden werden, aber dem zusätzlichen Aufwand stünden keine nennenswerten Vorteile gegenüber.

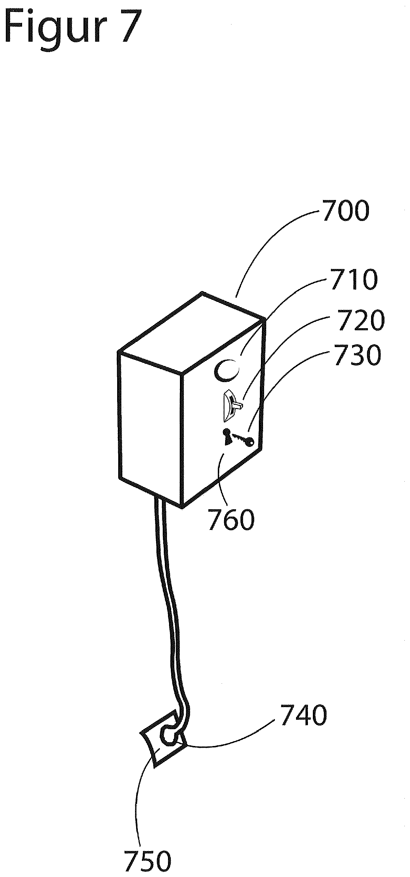

Figur 7 zeigt ein Gerät 700 zur Installation im Haushalt einer hilfsbedürftigen Person. Das Gerät kann in der Nähe einer Eingangstür an eine Wand geschraubt werden. Der Stecker 740 wird in eine Steckdose 750 gesteckt, um das Gerät 700 mit einem Elektrizitätszähler elektrisch zu verbinden. Das Gerät 700 weist einen ersten Schalter 720 zur Bedienung durch Besucher wie beispielsweise Angehörige auf.

Sobald ein Angehöriger den Haushalt betritt, legt er den Schalter 720 um, was das Gerät mit der Kontrollleuchte 710 quittiert. Gleichzeitig sendet das Gerät solange ein erstes Signal zum Elektrizitätszähler, bis der Angehörige den Schalter 720 in die Ausgangsposition zurücksetzt und den Haushalt verlässt. Der Elektrizitätszähler bzw. eine nachgeschaltete Vorrichtung zur Erkennung von Notfällen erkennt, dass in dem so markierten Zeitraum erfasste Aktivitäten nicht als Eigenaktivität der hilfsbedürftigen Person zu werten sind. Sobald ein Mitarbeiter eines Pflegedienstes den Haushalt betritt, steckt er einen Schlüssel 730 in einen Schlüsselschalter 760 und dreht den Schlüsselschalter 760 um, was das Gerät mit einer anderen Farbe der Kontrollleuchte 710 quittiert. Gleichzeitig sendet das Gerät solange ein zweites Signal zum Elektrizitätszähler, bis der Mitarbeiter den Schalter in die Ausgangsposition zurücksetzt und den Haushalt verlässt. Der Elektrizitätszähler bzw. eine nachgeschaltete Vorrichtung zur Erkennung von Notfällen erkennt, dass in dem so markierten Zeitraum erfasste Aktivitäten nicht der hilfsbedürftigen Person, sondern dem Mitarbeiter zuzurechnen sind.

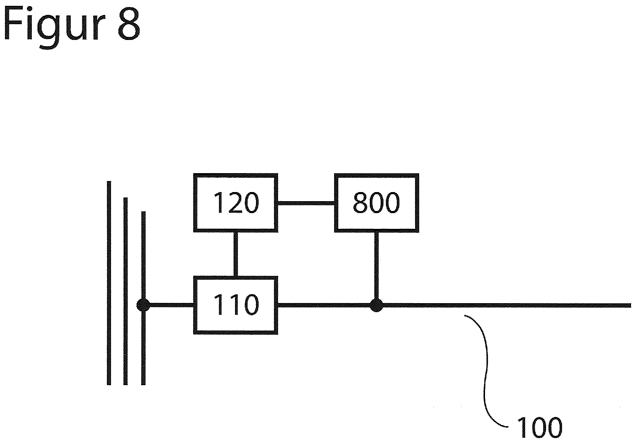

Figur 8 zeigt eine Prüfvorrichtung 800, die dazu ausgebildet ist, dauerhaft in einer elektrischen Installation 100 eines Haushalts installiert zu sein und einen Elektrizitätszähler 110 regelmäßig, beispielsweise täglich, auf korrekte Funktion seines Messwerks zu überprüfen. Dabei sollen sowohl Abweichungen durch Manipulationen wie parallel zum Zähler eingeschleifte Strompfade erkannt werden, als auch Abweichungen, die durch alterungsbedingte Veränderungen von Bauteilen bedingt sind.

Die Prüfvorrichtung 800 ist über die elektrische Installation 100 des Haushalts mit dem Elektrizitätszähler 110 verbunden. Die Prüfvorrichtung 800 ist dazu ausgebildet, den Verbrauch in der elektrischen Installation 100 sehr genau zu modulieren. Die Prüfvorrichtung 800 ist weiterhin dazu ausgebildet, mit einem Kommunikationsgerät 120 Daten zu tauschen und über das Kommunikationsgerät 120 mit dem Zähler zu kommunizieren. Die Prüfvorrichtung 800 informiert den Zähler, wann sie welches Prüfsignal in die elektrische Installation 100 einkoppelt, und beauftragt den Zähler, die zugeordnete Signalamplitude zu ermitteln. Der Zähler führt hierzu eine geeignete Korrelationsanalyse durch. Selbst für sehr geringe Amplituden des Prüfsignals ist diese Aufgabe einfach realisierbar, weil sehr lange Prüfzeiten, beispielsweise 24 Stunden, zulässig sind. Über so lange Prüfzeiten kann ein Prüfsignal auch dann problemlos gefunden werden, wenn seine Amplitude weit geringer ist als die Amplituden von Störsignalen. Am Ende dieser Prüfung vergleicht die Prüfvorrichtung 800 die vom Zähler ermittelte Signalamplitude mit der tatsächlich eingespeisten Signalamplitude. Im Falle einer sprunghaft aufgetretenen Abweichung, die auf eine Manipulation hindeutet, wird über das Kommunikationsgerät 120 eine erste Warnung an eine zentrale Stelle geschickt. Im Falle einer schleichenden Abweichung, die auf eine Alterung hindeutet, wird über das Kommunikationsgerät 120 eine zweite Warnung an eine zentrale Stelle geschickt. Zur Erzeugung des Prüfsignals wird in der Prüfvorrichtung 800 analog zur Ausführung gemäß Figur 4 ein Blindverbraucher geschaltet. Um eine schleichende Alterung der Prüfvorrichtung 800 zu vermeiden, wird dabei kein Elektrolytkondensator, sondern beispielsweise ein Keramikkondensator verwendet. In einer bevorzugten Ausführung ist die Prüfvorrichtung 800 fest in das Kommunikationsgerät 120 integriert und teilt mit diesem Gehäuse, Leiterplatte und CPU.

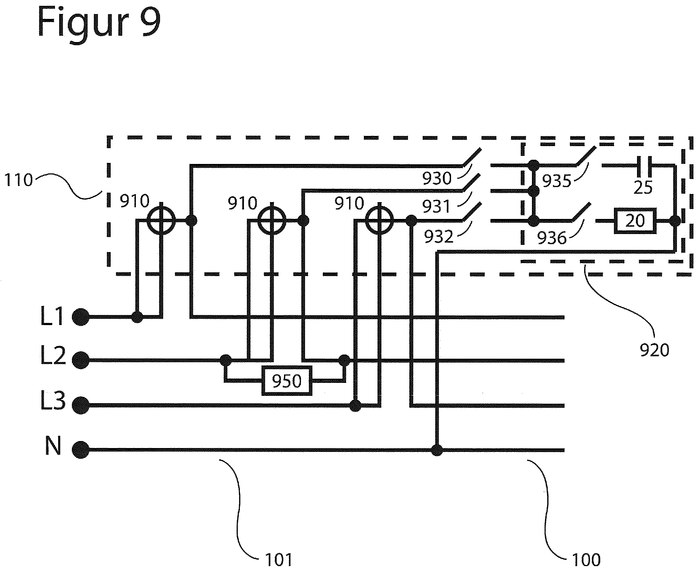

Figur 9 zeigt einen Elektrizitätszähler, der dazu ausgebildet ist, seine Messwerke automatisch zu testen. Hier ist der dreiphasige Fall vollständig dargestellt, während vorstehend zum Zwecke der einfacheren Darstellung jeweils nur der einphasige Fall gezeigt wurde. Der Elektrizitätszähler weist drei Messwerke 910 auf, die wie üblich mit dem öffentlichen Stromnetz 101 und der elektrischen Installation 100 eines Haushalts verbunden sind. Schalter 930, 931 und 932 sind dazu vorgesehen, für das Einkoppeln eines Testsignals auf genau eine Phase jeweils genau einen dieser Schalter durchzuschalten zu einer modulierbaren Impedanz 920. Sobald Schalter 930 durchschaltet, liegt die modulierbare Impedanz 920 elektrisch parallel zu den anderen, durch Phase 1 versorgten Verbrauchern. Die modulierbare Impedanz 920 wird gebildet aus einem Kondensator 25, der beispielsweise mit 10 nF bemessen ist und dazu vorgesehen ist, eine Blindleistung Q von -0,166 VAr zu beziehen, sobald der ihm zugeordnete Schalter 935 betätigt wird, und einem Widerstand 20, der beispielsweise mit 1 Megaohm bemessen ist und dazu vorgesehen ist, eine Wirkleistung P von 0,053 W zu verbrauchen, sobald der ihm zugeordnete Schalter 936 betätigt wird. Zur Überprüfung des ersten Messwerks wird Schalter 930 geschlossen. Dann wird mit Hilfe eines Zufallszahlengenerators eine zufällige Symbolfolge generiert und daraus gemäß der in Figur 6d gezeigten Kodierung eine Bitfolge abgeleitet. Entsprechend dieser Bitfolge wird der Schalter 935 sequentiell angesteuert. Während der Zeit, in der der Schalter 935 geschlossen ist, werden Blindleistungsmesswerte, die auf den Messwerten des ersten Messwerks basieren, in einem Blindleistungsintegrator aufintegriert. Weiterhin werden Wirkleistungsmesswerte, die auf den Messwerten des ersten Messwerks basieren, in einem Wirkleistungsintegrator aufintegriert. Während der Zeit, in der der Schalter 935 offen ist, werden die invertierten Messwerte in den gleichen Integratoren aufintegriert. Bei korrektem ersten Messwerk sind die Wirkleistungsmesswerte und die Ansteuerung des Schalter 935 unkorreliert, so dass der Wirkleistungsintegrator nach einer Messzeit von beispielsweise 10 Minuten im Wesentlichen leer ist. Der Blindleistungsintegrator enthält dagegen im Wesentlichen das Integral des Testsignals, das mit dem vorbekannten Sollwert verglichen wird. Im Anschluss wird auf die gleiche Art und Weise der Schalter 936 sequentiell angesteuert und danach werden die Tests für Phase 2 und 3 wiederholt. Neben Fehlern der Messwerke wird auch ein manipulationsbedingter Messfehler erkannt, der durch den Manipulations-Strompfad 950 bewirkt wird.

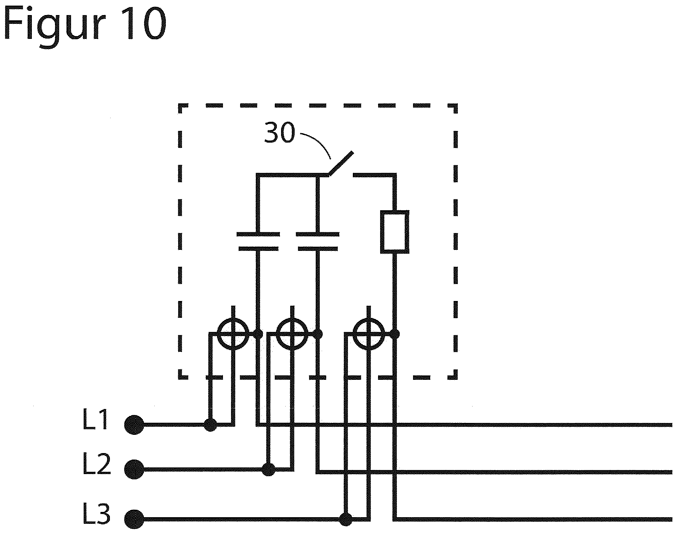

Figur 10 zeigt einen kostenoptimierten Elektrizitätszähler, der dazu ausgebildet ist, seine Messwerke automatisch zu testen. Um Schalter zu sparen, wird auf die Erzeugung unterschiedlicher Testzustände verzichtet. Wirk- und Blindleistungsmessung und die einzelnen Messwerke werden nicht separat überprüft, sondern durch einen einzigen Test, der überprüft, ob die auf den einzelnen Phasen aufmodulierte Scheinleistung jeweils korrekt gemessen wird. Dabei wird aus Kostengründen in Kauf genommen, dass die Testbedingungen für die einzelnen Phasen unterschiedlich und ggf. suboptimal sind. Da nur ein Schalter benötigt wird, kann ein hochwertiger Schalter eingesetzt werden, beispielsweise ein Reedkontakt, der für mindestens 10 Millionen Schaltzyklen ausgelegt ist und bauartbedingt keine diesen Test negativ beeinflussende Alterungserscheinungen ausbildet.

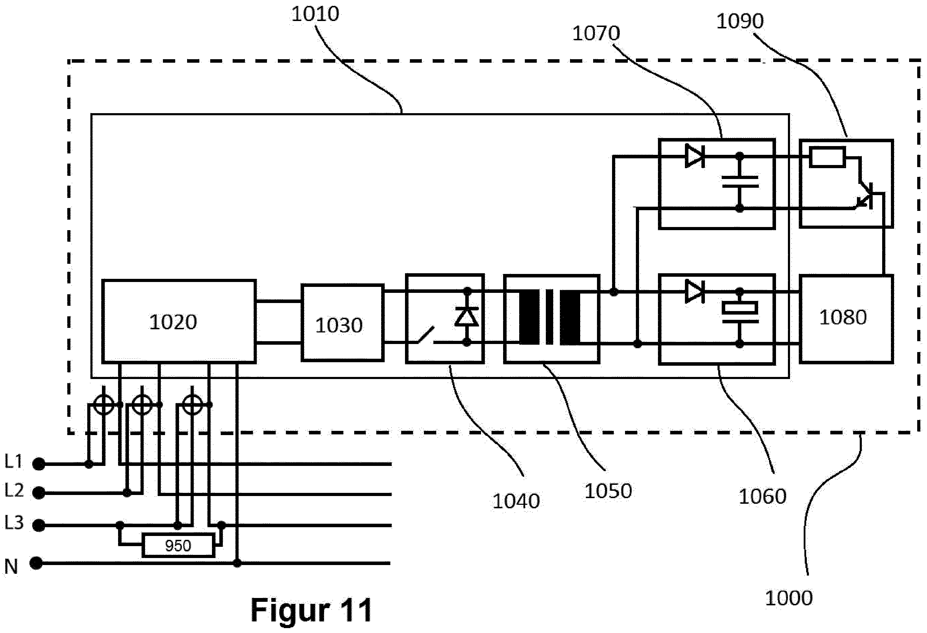

Figur 11 zeigt einen Elektrizitätszähler 1000 mit einer Steuerung 1080, einem modulierbaren Verbraucher 1090 und einem Schaltnetzteil 1010, das einen dreiphasigen Gleichrichter 1020, eine Glättungsschaltung 1030, einen Zerhacker 1040, einen Transformator 1050, eine zweite Glättungsschaltung 1060 und eine dritte Glättungsschaltung 1070 aufweist. Wie aus dem Stand der Technik bekannt, arbeitet das Schaltnetzteil mit einer Frequenz weit oberhalb der Netzfrequenz, Beispielsweise mit 20 kHz. Das bedeutet, der Zerhacker 1040 wird mit einer Frequenz von 20 kHz rechteckförmig angesteuert. Das bewirkt wie aus dem Stand der Technik bekannt einen Wechselstrom durch die Primärspule des Transformators 1050 und induziert wie bekannt eine Wechselspannung an seiner Sekundärspule, die wie bekannt durch die Glättungsschaltung 1060 gleichgerichtet wird.

Von dem Zerhacker 1040 sind symbolisch ein Schalter und eine Diode dargestellt. Ist der Schalter geschlossen, nimmt der Stromfluss durch den Transformator stetig zu, während die Diode sperrt. Wird der Schalter geöffnet, nimmt der Stromfluss durch den Transformator stetig ab und fließt durch die Diode. Von der Glättungsschaltung 1060 sind hier symbolisch eine Diode und ein Elektrolytkondensator dargestellt. Sie kann auch weitere Bauelemente, wie zusätzliche Drosseln und weitere Elektrolytkondensatoren, aufweisen. Von der Glättungsschaltung 1060 werden die Steuerung 1080 und weitere Komponenten wie A/D-Wandler etc. gespeist.

Die Steuerung 1080 benötigt eine wohldefinierte Spannungshöhe, weshalb das Schaltnetzteil 1010 hier nicht dargestellte Regelungsmittel aufweist, um die Spannungshöhe auf den Sollwert zu regeln. Die Steuerung 1080 ist hier also stellvertretend dargestellt für den typischen Niederspannungsteil eines Elektrizitätszählers. Die Besonderheit stellt in dieser Figur die dritte Glättungsschaltung 1070 dar, von der hier symbolisch eine Diode und ein Kondensator dargestellt sind. Dieser Kondensator ist sehr klein bemessen, dient zum Reduzieren eines Ripples und kann ggf. ganz entfallen.

Von der Glättungsschaltung 1070 wird der modulierbare Verbraucher 1090 gespeist, der hier symbolisch durch Widerstand und Transistor dargestellt ist. Dadurch, dass der modulierbare Verbraucher 1090 auf Niederspannungsseite angeordnet ist, sind die Anforderungen an die Spannungsfestigkeit seines Schaltelements reduziert. Dadurch, dass der modulierbare Verbraucher 1090 von einer präzise geregelten Spannung gespeist wird, ist der Betrag des von ihm bewirkten Stroms und der Betrag der von ihm verbrauchten Leistung sehr präzise bekannt. Die Steuerung 1080 ist dazu eingerichtet, den Verbraucher 1090 erfindungsgemäß zu modulieren. Das Schaltnetzteil 1010 weist einen üblichen Zusammenhang zwischen aufgenommener und abgegebener Leistung auf. Bei steigender abgegebener Leistung kommt es also zu einem Anstieg der aufgenommenen Leistung. Die durch den modulierbaren Verbraucher 1090 induzierte Modulation der vom Schaltnetzteil 1010 abgegebenen Leistung bewirkt eine Modulation der vom Schaltnetzteil 1010 aufgenommenen Leistung. Dabei ist lediglich zu berücksichtigen, dass in den Glättungsschaltungen 1030 und 1070 verbaute Kapazitäten so klein dimensioniert sind, dass die Grenzfrequenzen der durch diese Kapazitäten gebildeten Tiefpässe ausreichend hoch sind, um die Modulation passieren zu lassen. Der in der Glättungsschaltung 1060 vorgesehene Kondensator kann dagegen sehr groß dimensioniert werden, um eine sichere Versorgung der Steuerung 1080 zu gewährleisten, ohne dass dies die Modulation behindern würde.

Der Fachmann erkennt, dass die Steuerung 1080 bei einem symmetrischen Netzzustand symmetrisch aus allen drei Phasen gespeist wird. Das bedeutet, die Modulation des modulierbaren Verbraucher 1090 greift durch auf die Strommesswerke aller drei Phasen und führt zu einer Modulation der Strommesswerte. Wird an einer Phase zum Zwecke einer Manipulation bzw. eines Stromdiebstahls ein paralleler Strompfad eingerichtet, wie hier am Beispiel von L3 mit dem Strompfad 950 gezeigt, dann reduziert sich der durch den zugeordneten Stromsensor ermittelte Strommesswert. Dadurch reduziert sich die Differenz zwischen einem ersten Messwert der Momentanleistung, der bei stromlosem Verbraucher 1090 ermittelt wird, und einem zweiten Messwert der Momentanleistung, der bei bestromten Verbraucher 1090 ermittelt wird.

Bei einem unsymmetrischen Netzzustand sind die Verhältnisse komplizierter. Außerdem hängen die Verhältnisse vom Wirkungsgrad des Schaltnetzteils 1010 ab, der je nach Arbeitspunkt verschieden sein kann. Allerdings erhält die Steuerung 1080 aus ihren Messwerten für Strangspannungen und Strangströme alle notwendigen Informationen, um einerseits den momentanen Wirkungsgrad des Schaltnetzteils 1010 zu berechnen und andererseits die Leistungsanteile, die für die Versorgung des Zählers den einzelnen Phasen entnommen werden, zu bestimmen. Der Zusammenhang zwischen den Spannungshöhen der drei Phasen und den Leistungsanteilen ist typischerweise nichtlinear und kann beispielsweise in Tabellen hinterlegt sein.

## Patentansprüche

1. Verfahren zum Selbsttest der Messgenauigkeit eines Elektrizitätszählers (110), der zur Bildung von Verrechnungsdaten ausgelegt ist, wobei aus Messwerten eines Messwerks (910) des Elektrizitätszählers (110) Verbrauchswerte und/oder Leistungswerte ermittelt werden und die Verbrauchswerte und/oder Leistungswerte mit einer von einer Prüfvorrichtung (800) vorgenommenen, vorgegebenen Modulation eines modulierbaren Leistungsverbrauchers in Beziehung gebracht werden, um die Funktion des Messwerks (910) zu überprüfen.

2. Vorrichtung mit einem zur Bildung von Verrechnungsdaten ausgelegten Elektrizitätszähler (110), wobei die Vorrichtung dazu ausgebildet ist, aus Messwerten eines Messwerks (910) des Elektrizitätszählers (110) Verbrauchswerte und/oder Leistungswerte zu ermitteln und wobei die Vorrichtung zur Übertragung von Signalen und/oder Daten über ein vorhandenes Stromnetz (100) mit einem modulierbaren Leistungsverbraucher ausgebildet ist und dazu, aus den Verbrauchswerten und/oder Leistungswerten von dem modulierbaren Leistungsverbraucher übertragene Signale und/oder Daten zu rekonstruieren, **dadurch gekennzeichnet, dass** der modulierbare Leistungsverbraucher eine Prüfvorrichtung (900) aufweist, die dazu ausgebildet ist, eine vorgegebene Modulation des Verbrauchs vorzunehmen, wobei ein Selbsttest der Messgenauigkeit des Elektrizitätszählers (110) vorgesehen ist, bei dem die Verbrauchswerte und/oder Leistungswerte mit der Modulation des modulierbaren Leistungsverbrauchers in Beziehung gebracht werden, um die Funktion des Messwerks (910) zu überprüfen.

3. Vorrichtung nach Anspruch 2, **dadurch gekennzeichnet, dass** der modulierbare Leistungsverbraucher in den Elektrizitätszähler (110) integriert ist.

4. Vorrichtung nach Anspruch 3, **dadurch gekennzeichnet, dass** der Elektrizitätszähler (110) ein Schaltnetzteil (1010) aufweist, an dessen Niederspannungsseite der modulierbare Leistungsverbraucher angeschlossen ist.

5. Vorrichtung nach Anspruch 4, **dadurch gekennzeichnet, dass** das Schaltnetzteil (1010) eine Spannungsglättungschaltung (1030) aufweist, an die ausschließlich der modulierbare Leistungsverbraucher angeschlossen ist.

## Claims

1. Method for self-testing the measuring accuracy of an electricity meter (110) which is designed to form billing data, wherein consumption values and/or power values are determined from measured values of a measuring mechanism (910) of the electricity meter (110) and the consumption values and/or power values are compared with a predetermined modulation of a modulatable power consumer which is carried out by a testing device (800) in order to monitor the function of the measuring mechanism (910).

2. Device having an electricity meter (110) designed to generate billing data, the device being designed to determine consumption values and/or power values from measured values of a measuring mechanism (910) of the electricity meter (110), and the device being designed to transmit signals and/or data via an existing power network (100) having a modulatable power consumer and to reconstruct signals and/or data transmitted by the modulatable power consumer from the consumption values and/or power values, **characterized in that** the modulatable power consumer comprises a testing device (900) adapted to perform a predetermined modulation of the consumption, wherein a self-test of the measuring accuracy of the electricity meter (110) is provided in which the consumption values and/or power values are related to the modulation of the modulatable power consumer to test the function of the measuring mechanism (910).

3. Device according to claim 2, **characterized in that** the modulatable power consumer is integrated into the electricity meter (110).

4. Device according to Claim 3, **characterized in that** the electricity meter (110) has a switched-mode power supply (1010), to the low-voltage side of which the modulatable power consumer is connected.

5. Device according to Claim 4, **characterized in that** the switched-mode power supply (1010) has a voltage smoothing circuit (1030) to which only the modulatable power consumer is connected.

## Revendications

1. Procédé pour l'autotest de l'exactitude de mesure d'un compteur d'électricité (110), lequel est conçu pour la formation de données de facturation, dans lequel des valeurs de consommation et/ou des valeurs de puissance sont déterminées à partir de valeurs de mesure d'un instrument de mesure (910) du compteur d'électricité (110) et les valeurs de consommation et/ou les valeurs de puissance sont mises en relation avec une modulation prédéfinie, réalisée par un dispositif de contrôle (800), d'un consommateur de puissance modulable, afin de contrôler le fonctionnement de l'instrument de mesure (910).

2. Dispositif comprenant un compteur d'électricité (110) conçu pour former des données de facturation, dans lequel le dispositif est adapté pour déterminer des valeurs de consommation et/ou des valeurs de puissance à partir de valeurs de mesure d'un instrument de mesure (910) du compteur d'électricité (110) et dans lequel le dispositif est adapté pour transmettre des signaux et/ou des données par le biais d'un réseau électrique existant (100) avec un consommateur de puissance modulable et pour reconstruire des signaux et/ou des données transmis/transmises par le consommateur de puissance modulable à partir des valeurs de consommation et/ou des valeurs de puissance, **caractérisé en ce que** le consommateur de puissance modulable présente un dispositif de contrôle (900) adapté pour réaliser une modulation prédéfinie du consommateur, où il est prévu un autotest de l'exactitude de mesure du compteur d'électricité (110), dans lequel les valeurs de consommation et/ou les valeurs de puissance sont mises en relation avec la modulation du consommateur de puissance modulable, afin de contrôler le fonctionnement de l'instrument de mesure (910).

3. Dispositif selon la revendication 2, **caractérisé en ce que** le consommateur de puissance modulable est intégré dans le compteur d'électricité (110).

4. Dispositif selon la revendication 3, **caractérisé en ce que** le compteur d'électricité (110) présente une partie de réseau de commutation (1010), au côté basse tension de laquelle est raccordé le consommateur de puissance modulable.

5. Dispositif selon la revendication 4, **caractérisé en ce que** la partie de réseau de commutation (1010) présente un circuit de lissage de tension (1030) auquel est raccordé exclusivement le consommateur de puissance modulable.
